# FASCICULE DE BREVET EUROPEEN

(11) **EP 2 343 561 B1**
(45) Date de publication et mention de la délivrance du brevet: **31.07.2019**
(21) Numéro de dépôt: 10015851.8
(22) Date de dépôt: 21.12.2010
(51) Int. Cl.: G01R 35/04

(54) **Procédé et système pour vérifier l'état de calibration d'un compteur d'énergie électrique embarqué dans un véhicule ferroviaire**
Verfahren und System zur Überprüfung des Kalibrierungszustandes eines an Bord eines Schienenfahrzeugs installierten Elektrizitätszählers
Method and system for verifying the calibration state of an electricity meter installed on-board a railway vehicle

(30) Priorité: 07.01.2010 FR 1000059
(43) Date de publication de la demande: 13.07.2011
(73) Titulaire: COMECA POWER, 72100 Le Mans (FR)
(72) Inventeur: Maurel, Alain, 69007 Lyon (FR); Raulet, Claude, 69580 Sathonay village (FR); Rigaud, Franck, 01600 Reyrieux (FR)
(74) Mandataire: Gevers & Orès

(56) Documents cités:
- EP-A1- 1 126 640
- EP-A2- 1 947 465
- US-B1- 6 262 569
- US-B2- 6 815 942
- ANONYMOUS: "Moving Test - MT3000; Three-Phase Portable Test System", INTERNET CITATION, 30 July 2008 (2008-07-30), pages 1-8, XP002548827, Retrieved from the Internet: URL:http://www.zera.de/typo3conf/ext/nf_do wnloads/pi1/passdownload.php?downloaddata= 92 [retrieved on 2009-09-30]

## Description

### Domaine technique

L'invention concerne le domaine de la mesure de la consommation électrique, et plus particulièrement le domaine des compteurs d'énergie électrique embarqués dans un engin de traction ferroviaire.

### Etat de la technique

Les exploitants de lignes ferroviaires doivent payer la consommation d'énergie électrique de leurs véhicules ferroviaires, et notamment de leurs engins de traction. Cette consommation peut être estimée en fonction notamment de la distance parcourue, ou mesurée à l'aide d'instruments de mesure spécifiques. Ainsi, de plus en plus d'engins ferroviaires sont équipés de compteurs d'énergie. Ces instruments de mesure sont de conception assez complexe, car certains engins ferroviaires, et notamment ceux qui sont destinés à être exploités sur des lignes transfrontalières, doivent pouvoir être alimentés par différentes valeurs de tension, et cela tant sous la forme d'une tension de courant continu (dont la tension est par exemple de 1,5 kV, de 3 kV ou de 0,75 kV) que sous la forme d'une tension de courant alternatif (dont la tension est par exemple de 15 kV à une fréquence de 16,7 Hz ou de 25 kV à 50 Hz).

Un engin de traction ferroviaire représente un environnement électrique et électromagnétique assez rude pour des instruments de mesure, dû à la présence de fortes intensités de courant de haute tension, de champs électromagnétiques, d'interférences radioélectriques, de vibrations, chocs et secousses mécaniques, de conditions de température et d'humidité changeantes, d'insectes et d'autres animaux. Les compteurs d'énergie embarqués à bord des trains doivent répondre, d'une manière générale, aux exigences de la norme européenne EN 50155 « Applications ferroviaires - Equipements électriques utilisées sur le matériel roulant », et plus particulièrement aux exigences de la norme européenne EN 50463 « Applications ferroviaires - Mesure d'énergie à bord des trains ».

D'une manière générale, afin que l'affichage de ces instruments de mesure embarqués puisse être utilisé directement pour établir la consommation de manière contradictoire entre le fournisseur d'énergie électrique et le consommateur d'énergie électrique, ces instruments sont des instruments certifiés et plombés. Ceux-ci doivent être vérifiés et recertifiés périodiquement par un organisme indépendant. Pour ce faire, l'engin ferroviaire doit être immobilisé, ce qui conduit à des contraintes en termes de planning de l'exploitation, et à un coût d'immobilisation. Comme il sera expliqué ci-dessous en détail, la présente invention vise à proposer un dispositif et un procédé permettant de minimiser la fréquence de cette immobilisation.

La mesure de la consommation électrique d'un engin ferroviaire a fait l'objet d'un certain nombre d'inventions. D'une manière générale, les tensions et courants utilisés pour alimenter des engins de traction ferroviaire sont trop élevés pour être directement raccordés au compteur d'énergie. Ainsi, il est nécessaire d'utiliser des capteurs de tension et de courant, i.e. des transformateurs de mesure, pour amener les niveaux de tension et de courant à un niveau acceptable par une électronique de mesure. Un schéma d'un tel circuit selon l'état de la technique est montré sur la figure 1. A titre d'exemple, la demande de brevet FR 2 911 541 (Faiveley Transport) décrit un dispositif de mesure de courant consommé par un engin de traction ferroviaire qui détermine une différence de potentiel proportionnelle au courant circulant sur un tronçon d'un organe de captage de courant. Ce dispositif se prête à l'usage dans un engin de traction multi-tension.

D'une manière générale, on connait de nombreux systèmes qui mesurent la puissance électrique consommée dans un circuit électrique et qui comportent une fonction de calibration du signal de réponse du système. Certains sont conçus pour être portable, d'autres sont conçus pour permettre une auto-calibration.

Le brevet US 6,262,569 B1 décrit un système portable de test d'appareils de mesure de l'électricité. Le brevet US 4,646,003 (Southern California Edison Company) décrit un autre appareil portable autonome pour contrôler la précision d'un watt-heuremètre à son site d'exploitation, en étant électriquement interposé entre le compteur et la ligne de courant électrique, ayant des bornes du réseau et des bornes de charge et une charge. L'appareil comprend un moyen formant charge fantôme adapté à une connexion auxdites bornes du réseau et auxdites bornes de charge, le moyen formant charge fantôme ayant une faible charge représentative d'une charge supérieure au compteur et comprenant un transformateur de charge, un transducteur de watts relié audit transformateur de charge, et un moyen pour calculer, sur une période de temps, les watt-heures à travers le transducteur de watts relativement aux watt-heures à travers le compteur pour ainsi donner une information représentative de la précision du compteur.

Le brevet US 5,325,048 (Digital KWH Inc.) décrit un appareil et un procédé de calibrage d'un appareil de mesure numérique de la consommation d'électricité. L'appareil comprend un ordinateur pour générer les facteurs de calibrage.

La demande de brevet WO 97/15806 (Sydkraft AB) décrit un système de contrôle d'un dispositif de mesure de l'énergie électrique connecté à un réseau haute tension et qui est utilisé pour mesurer l'énergie consommée dans une usine. Le système de contrôle comprend une unité de mesure de l'énergie, une unité de détection de courant connectée à l'unité de mesure de l'énergie et adaptée pour détecter le courant consommé, et une unité de détection de tension connectée à l'unité de mesure de l'énergie et adaptées pour détecter la tension correspondante. Le système de contrôle est mobile et comprend un moyen de génération de haute tension à connecter à l'unité de détection de tension de l'unité de mesure de l'énergie du système, un moyen de génération de fort courant à connecter à l'unité de détection de courant de l'unité de mesure de l'énergie du système, un moyen de génération de courant normal connecté au moyen de génération de fort courant et adapté pour générer un courant normal, un moyen de génération de tension normale relié au moyen de génération de haute tension adapté pour générer une tension normale, et une unité de comparaison, qui est connectée au moyen de génération de courant normal pour recevoir le courant normal et au moyen de génération de tension normale pour la réception de la tension normale et qui est adapté pour être connecté à l'unité de mesure de l'énergie pour la réception d'une valeur mesurée, déterminée par l'unité de mesure de l'énergie, de l'énergie consommée, l'unité de comparaison étant adapté pour déterminer une valeur normale de l'énergie consommée et pour comparer la valeur normale avec la valeur mesurée et déterminer la différence, ladite différence étant une mesure de l'erreur totale de mesure du système de mesure de l'énergie.

Le brevet US 7,239,125 (Elster Electricity, LLC) décrit un système électronique de mesure de l'énergie qui mesure la puissance réelle, la puissance réactive et la puissance apparente. Il comprend une interface de communication et un système de traitement couplé à l'interface de communication, qui génère un signal de test sous forme d'impulsion, représentatif de l'ordre de grandeur de la puissance à mesurer, ledit système de traitement transmettant le signal de test à un dispositif testeur externe à l'appareil de mesure via l'interface de communication.

La demande de brevet EP 1 498 741 A1 (Iskraemeco) décrit un wattheuremètre comportant un circuit spécifique comportant quatre commutateurs qui permettent de réaliser une fonction d'autotest intégrée.

Le brevet US 6,815,942 (Landis+Gyr, Inc.) décrit un appareil de mesure de l'électricité capable de réaliser des opérations d'auto-calibrage. L'appareil comporte un circuit de mesure configuré pour recevoir un signal de test et générer une information de mesure de puissance correspondant au signal de test, une entrée configurée pour recevoir une information standard générée à l'extérieur de l'appareil et correspondant au signal de test, et un contrôleur couplé à l'entrée et au circuit de mesure, le contrôleur comparant l'information de mesure générée par le circuit de mesure à l'information standard générée et génère un signal de compensation dépendant du résultat de la comparaison. Le signal de compensation est utilisé pour auto-calibrer l'appareil de mesure.

Le brevet EP 0 803 741 B1 (ABB Power T&D Company Inc.) décrit un compteur d'énergie doté d'un moyen de test de son fonctionnement. Le compteur comporte des moyens pour détecter des signaux de tension et de courant d'entrée, un système de traitement pour traiter les signaux de courant et de tension en vue de générer une mesure de puissance et un signal pulsé et un moyen de sortie couplé au système de traitement pour sortir du compteur le signal pulsé. Le système de traitement traite les signaux d'entrée et de sortie en vue de générer une pluralité de mesures de puissance. Le signal pulsé est un signal d'essai pour tester le fonctionnement du compteur. Le moyen de sortie comprend un port de communication optique pour transmettre le signal d'essai pulsé provenant du compteur à un dispositif d'essai externe au compteur.

La demande de brevet FR 2 625 323 (Electricité de France) concerne un dispositif d'interfaçage pour panneau de comptage d'énergie électrique monophasé ou triphasé pourvu de trois boites d'essai permettant l'accès aux circuits de tension et d'intensité des compteurs pour l'étalonnage de ceux-ci. Le panneau comporte des moyens de liaison aux boites d'essai du panneau de comptage, des moyens de liaison à un compteur étalon, des moyens de liaison à une source autonome de tension et d'intensité, des moyens de commutation pour, sélectivement sur chacune des phases, substituer à la tension appliquée au compteur une tension générée par la source autonome et placer sur cette phase un voltmètre, des moyens de commutation pour, sélectivement sur chacune des phases, substituer à l'intensité traversant le compteur une intensité générée par la source autonome et intercaler sur cette phase un ampèremètre.

La demande de brevet EP 0 240 102 A2 (Robinton Products Inc.) décrit un appareil de mesure de puissance électrique possédant des capacités d'autotest interne, et qui comprend : des moyens pour produire un premier signal analogique indicatif de l'un parmi un courant ou une tension porté par une ligne et des moyens pour produire un second signal analogique indicatif de l'autre parmi le courant ou la tension ; un premier moyen de modulation pour produire un premier signal modulé variable entre deux niveaux et indicatif de la grandeur dudit premier signal analogique ; un premier moyen de multiplication pour produire un premier signal de produit à partir dudit premier signal modulé et dudit premier signal analogique, qui est indicatif de la puissance portée par la ligne ; un premier convertisseur pour produire un premier signal converti à partir dudit premier signal de produit sous la forme d'un train d'impulsions, chacune de ces impulsions représentant une quantité prédéterminée de puissance portée par la ligne ; des premiers moyens de test pour appliquer momentanément un premier signal de test à une entrée dudit moyen de modulation au lieu du premier signal analogique ; une première mémoire pour stocker une première valeur de signal convertie qui correspond audit premier signal de test ; un premier comparateur pour produire un premier signal d'erreur lorsque ledit signal converti diffère de ladite valeur de premier signal converti stockée de plus d'une quantité prédéterminée lorsque ledit premier signal de test est appliqué audit premier moyen de modulation.

La demande de brevet WO 01/51937 A1 (Embretsen) décrit un appareil de mesure de l'électricité comprenant un circuit de courant et un dispositif de calibrage pour influencer un courant moyen circulant dans le circuit de courant, caractérisé en ce que le dispositif de calibrage comprend un commutateur qui, avec un rapport temps de conduction sur temps de non conduction influence le courant moyen dans le circuit de courant.

Aucun de ces systèmes ou appareils n'est conçu pour une utilisation embarquée dans un engin ferroviaire.

### Objet de l'invention

Un premier objet de l'invention est un procédé tel que défini dans la revendication 1.

Le signal étalon est généré par un simulateur des références, capable notamment de générer des signaux de courant et de tension précis. Le résultat de ladite vérification, i.e. les informations obtenues par ledit procédé sur l'état de fonctionnement dudit compteur d'énergie électrique, peut être géré localement (i.e. par un dispositif d'affichage et/ou d'enregistrement) ou à distance, typiquement par une liaison de signal sans fil, tel qu'une liaison radio. Dans le cas d'une gestion à distance, le résultat de la vérification est transmis par le vérificateur embarqué vers un récepteur de signal sans fil externe à l'engin ferroviaire, par l'intermédiaire d'un émetteur de signal sans fil. Ledit récepteur est capable d'afficher et/ou enregistrer les informations au moyen d'un dispositif d'affichage et/ou d'enregistrement. Dans les deux cas (gestion locale ou gestion à distance), le résultat de la vérification ainsi transmis, affiché et/ou enregistré peut comprendre les réponses individuelles R(E) et les signaux étalons (E), et/ou décision que l'instrument est toujours ou n'est plus en bon état de calibration. Dans une étape finale, optionnelle, on prévient l'exploitant et / ou le fournisseur d'énergie, afin qu'ils fassent recalibrer ledit compteur d'énergie électrique ; cela peut se faire également de manière automatique par une liaison filaire ou sans fil.

Dans le procédé selon l'invention, on peut utiliser une pluralité de n signaux étalon E₁, ..., Eₙ, qui sont réparties selon un schéma prédéfini sur la plage d'étalonnage. Dans un mode de réalisation, ledit signal étalon E peut être un courant électrique.

Dans un autre mode de réalisation pouvant être combiné avec tous les autres modes de réalisation, le procédé est exploité dans un engin ferroviaire comportant une alimentation de traction électrique en liaison électrique avec un capteur de mesure de tension et un capteur de mesure de courant, ainsi que ledit vérificateur embarqué, ledit vérificateur embarqué comprenant un simulateur des références, une unité de gestion, un premier commutateur en liaison électrique avec le capteur de mesure de tension, et un deuxième commutateur en liaison électrique et le capteur de mesure de courant, lesdits capteurs étant situés à l'extérieur dudit vérificateur embarqué et en liaison électrique avec l'alimentation de traction.

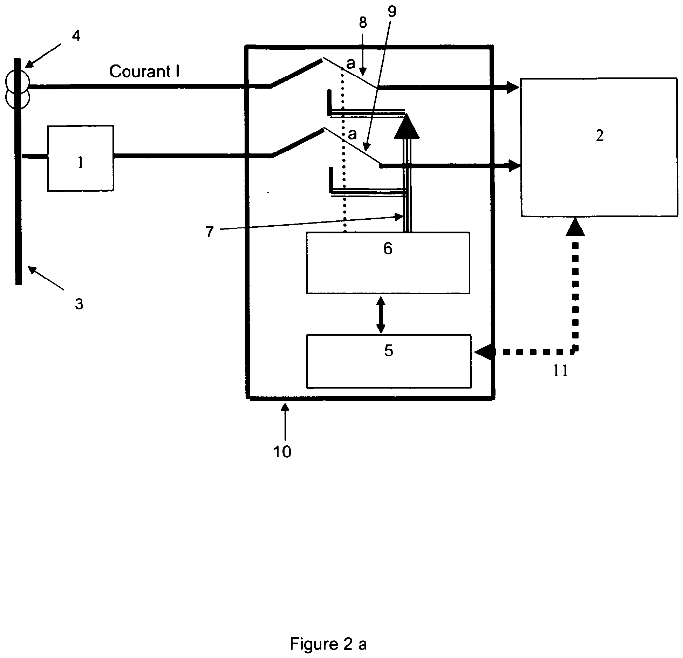

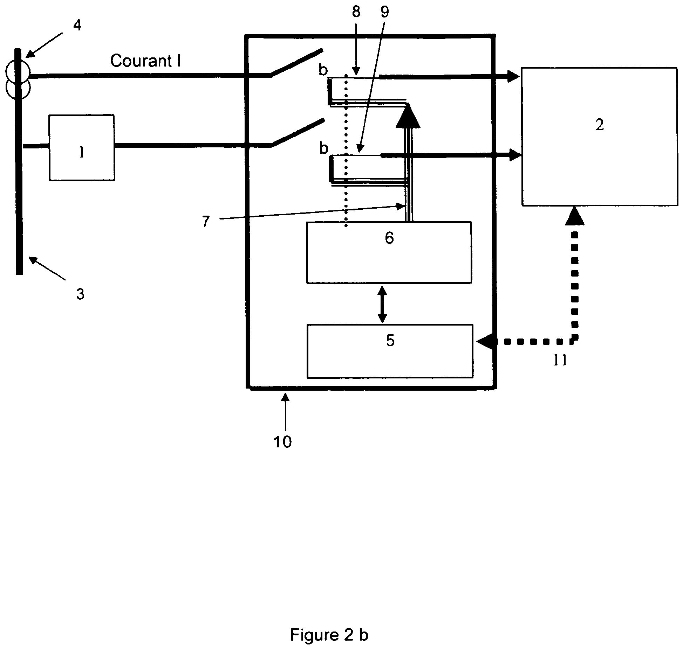

Dans le procédé selon l'invention,
- on reçoit un ordre local ou distant de test ;
- on initialise la vérification dudit compteur d'énergie électrique, en effectuant les étapes suivantes :
   (A) on initialise le dialogue entre le compteur d'énergie électrique et le vérificateur embarqué ;
   (B) le vérificateur embarqué passe du mode dit « comptage » en mode dit « vérification », en basculant les premier et deuxième commutateurs de la position (a) en position (b), telle que définies sur les figures 2a et 2b, de manière à ce que les signaux électriques issues des capteurs et précédemment envoyés vers le compteur d'énergie électrique sont remplacées par les signaux étalon E générés par le simulateur des références ,
   (C) on effectue les étapes (i) à (iv) ;
   (D) on établit un compte rendu de test, soit localement soit à distance ;
   (E) le vérificateur embarqué passe du mode de vérification en mode comptage, en basculant les premier et deuxième commutateurs de la position (b) en position (a), de manière à ce que les signaux étalon E issus du simulateur des références qui étaient à l'étape (B) envoyés vers le compteur d'énergie électrique sont remplacées par les signaux issues des capteurs,
   sachant que l'étape (D) peut être effectuée avant ou après l'étape (E), ou encore pendant l'étape (C-iii) et/ou (C-iv).

Ledit signal étalon E peut être sélectionné parmi les signaux électriques en courant continu et les signaux électriques en courant alternatif, et dans ce dernier cas avantageusement dans le groupe formé par les signaux électriques en courant alternatif de fréquence nominale 50 Hz et les signaux électriques en courant alternatif de fréquence nominale 16 Hz 2/3.

Le procédé peut comporter en plus une étape de transmission d'informations sur l'état de calibration dudit compteur d'énergie électrique embarqué par un émetteur embarqué de signal sans fil et relié au vérificateur embarqué vers un récepteur externe audit engin ferroviaire, ladite transmission d'information étant effectuée par l'intermédiaire d'une liaison sans fil.

Un autre objet de l'invention est un engin ferroviaire tel que défini dans la revendication 5.

Le vérificateur embarqué comprend un premier commutateur électriquement relié à un capteur de courant, et un second commutateur électriquement relié à un capteur de tension, lesdits capteurs étant électriquement reliés à l'alimentation de traction dudit engin ferroviaire.

### Figures

La figure 1 montre un dispositif selon l'état de la technique.
La figure 2 montre un dispositif selon l'invention, avec deux positions différentes (a) et (b) des interrupteurs (figures 2a et 2b).

### Liste des repères :

- 1: Capteur de mesure de tension
- 2: Compteur d'énergie
- 3: Alimentation de traction (pantographe en contact avec le fil caténaire)
- 4: Capteur de mesure de courant
- 5: Unité de gestion
- 6: Simulateur des références U et I
- 7: Liaison de signal
- 8: Premier commutateur
- 9: Second commutateur
- 10: Vérificateur embarqué
- 11: Liaison de communication

### Description

Le terme « compteur d'énergie » signifie, comme dans la norme EN 50463 :2008-06, un « instrument conçu pour mesurer la quantité d'énergie électrique en intégrant la puissance en fonction du temps. »

Les inventeurs se sont rendu compte que souvent la recertification du compteur d'énergie est effectuée alors que le compteur d'énergie ne montre pas encore de dérive appréciable. Dans ces cas, il aurait été envisageable de repousser l'échéance de la prochaine recertification à une date ultérieure au lieu d'immobiliser l'engin de traction ferroviaire inutilement pour la recertification. En pratique, la recertification est préconisée le plus souvent à des intervalles de temps prédéfinis, quel que soit l'état de calibration réel de l'appareil.

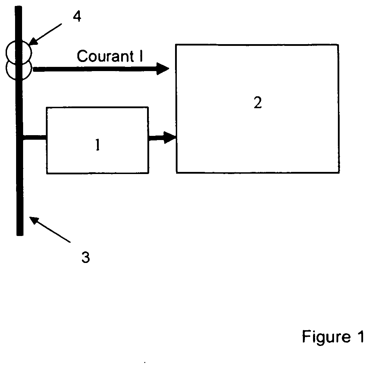

Le procédé selon l'invention permet de repousser la recertification jusqu'à ce qu'une dérive du compteur d'énergie ait été détectée, qui dépasse une valeur prédéfinie, ou au moins de rallonger les intervalles de temps jusqu'à la prochaine recertification en suivant régulièrement l'état de calibration du compteur d'énergie. La figure 1 montre de manière schématique un compteur d'énergie **2** selon l'état de la technique. L'alimentation de traction **3** est typiquement un pantographe doté d'un frotteur en contact dynamique avec le fil caténaire, ou un frotteur de type patin. Un capteur de mesure de tension **1** est intercalé entre l'alimentation de traction **3** et le compteur d'énergie **2** pour diminuer la tension vue par ce dernier. Un capteur de mesure de courant **4** est intercalé entre l'alimentation de traction **3** et le compteur d'énergie pour diminuer le courant vu par ce dernier. Si le courant à mesurer est un courant alternatif, les capteurs de mesure **1,4** sont des transformateurs.

Selon l'invention, on branche un générateur de signaux électriques étalons (appelé ici « simulateur de références de courant et de tension » **6**) en amont du compteur d'énergie **2** à vérifier, et on injecte un courant étalon de caractéristiques connues. On mesure la réponse en sortie de l'instrument (dans le cas présent : du compteur d'énergie **2**) à vérifier. Si cette réponse se situe à l'intérieur de l'intervalle de confiance jugé acceptable, on constate que l'instrument est toujours en bon état de calibration. Si cette réponse se situe à l'extérieur de l'intervalle de confiance jugé acceptable, on constate que l'instrument **2** n'est plus en bon état de calibration, et on prévient l'exploitant de l'engin de traction ferroviaire et / ou le fournisseur d'énergie, afin qu'ils fassent recalibrer l'instrument **2**.

La figure 2 montre le schéma d'un dispositif vérificateur embarqué **10** selon l'invention. Ce dispositif comprend un simulateur des références de courant et de tension **6** permettant d'injecter des tensions et des courants de référence dans le compteur d'énergie **2** pour vérifier l'état de calibration de ce dernier. Le résultat de cette vérification peut être géré localement (i.e. par un dispositif d'affichage et/ou d'enregistrement) ou à distance, typiquement par une liaison de signal sans fil, tel qu'une liaison radio. Dans le cas d'une gestion à distance, le résultat de la vérification, qui peut comprendre les mesures individuelles est transmis par le vérificateur embarqué vers un récepteur de signal sans fil externe à l'engin ferroviaire, par l'intermédiaire d'un émetteur de signal sans fil.

Lorsque la fonction de vérification est inactive (mode dit « veille »), les premier et deuxième commutateurs **8** et **9** sont en position (a), et les signaux U et I sont directement transmis au compteur d'énergie **2** sans transformation ni altération.

Lorsqu'une commande vérification est demandée, la fonction de simulation des références est activée par un signal transmis à travers la liaison de signal **7**. Cette dernière peut être une liaison à fil ou sans fil. Les premier et deuxième commutateurs **8** et **9** sont alors commutés en position (b) (mode dit « vérification »). Cet aiguillage permet d'imposer au compteur d'énergie **2** les signaux de référence émis par le simulateur des références **6** en entrée. La liaison de communication **11** entre le vérificateur embarqué **10** et le compteur d'énergie **2** est activée, et les signaux mesurés par le compteur d'énergie **2** sont transmis à l'unité de gestion **5**. L'activation de la ligne de communication **11** peut se faire en même temps que la commutation des commutateurs **8** et **9**, mais elle peut se faire aussi avant ou après. Dans le mode de réalisation montré sur la figure 2, l'unité de gestion est intégrée dans le vérificateur embarqué **10**, mais dans un autre mode de réalisation, elle peut se situer à l'extérieur de celui-ci.

Le simulateur de références de courant et de tension **6** est capable de générer les tensions et les courants appliqués qui sont l'image de chaque tension caténaire utilisée, et pour chaque type d'image caténaire le simulateur de références **6** doit être capable de parcourir l'ensemble des quadrants pour la tension et le courant.

L'unité de gestion **5** du vérificateur embarqué **10** comprend avantageusement au moins un microprocesseur. Elle pilote le simulateur de références **6** en lui communiquant des points remarquables qui ont valeur de référence, et vérifie par la liaison de communication **11** les valeurs des consommations calculées par le compteur d'énergie **2** pour chaque point remarquable.

Nous décrivons ici un procédé d'utilisation du dispositif selon l'invention.

Dans une première étape, le vérificateur embarqué **10**, qui se trouve en mode « veille », reçoit un ordre local ou distant de procéder à une vérification. Le mode vérification est alors initialisé ; cette deuxième étape comprend notamment l'initialisation du dialogue entre le compteur d'énergie **2** et le vérificateur embarqué **10**, et le passage du compteur d'énergie **2** en mode vérification. Cela comprend également l'aiguillage des signaux vus par le compteur d'énergie **2**, c'est-à-dire le passage des premier et deuxième commutateur **8**, **9** en position (b) : les informations issues des capteurs sont basculées au profit des signaux de référence générés par le simulateur des références de tension et de courant **6** du vérificateur embarqué **10**. Ensuite, le simulateur des références de tension et de courant **6** émet au moins un, et de préférence une pluralité, de signaux de curant et / ou de tension. Ensuite, dans une troisième étape, le vérificateur embarqué **10** établit un compte rendu de test, qui peut être stocké et/ou affiché localement, ou émis à un récepteur distant. Ensuite, le système bascule en mode veille, c'est-à-dire que les premier et deuxième commutateur **8**, **9** rebasculent en position (a), de manière à ce que le compteur d'énergie **2** puisse compter l'énergie consommée par l'engin.

D'une manière générale, le procédé selon l'invention comporte les étapes suivantes :
(1) Réception d'un ordre local ou distant de procéder à une vérification ;
(2) Initialisation de la vérification :
   Cette étape comprend notamment les étapes suivantes :
   - Initialisation du dialogue entre le compteur d'énergie **2** et le vérificateur **10** et passage du compteur d'énergie **2** en mode de vérification ;
   - Pilotage de la fonction d'aiguillage (les informations issues des capteurs **1,4** sont basculées au profit des signaux de référence générés par le simulateur des références **6** du vérificateur **10** embarqué) ;
(3) Génération des signaux de référence par le simulateur des références **6** :
   Le déroulement précis de cette étape dépend de la nature des courants qui alimentent l'engin ferroviaire. Nous donnons ici trois exemples pour des cas fréquents :

### 1. Signaux DC

- Test de la consommation sur l'ensemble de la plage d'entrée du compteur d'énergie **2** et vérification du vérificateur **10** embarqué des puissances calculées par le compteur d'énergie **2**,
- Simulation de réjection sur l'ensemble de la plage d'entrée du compteur d'énergie **2** et vérification par le vérificateur embarqué **10** des puissances calculées par le compteur d'énergie **2** ;

### 2. Signaux AC / 50Hz

- Test de la consommation active et réactive sur l'ensemble des quadrants consommées et rejectées avec vérification par le vérificateur embarqué **10** des puissances calculées par le compteur d'énergie **2** ;

### 3. Signaux AC / 16Hz 2/3

- Test de la consommation active et réactive sur l'ensemble des quadrants consommées et réjectées avec vérification par le vérificateur embarqué **10** des puissances calculées par le compteur d'énergie **2**,

### (4) Compte rendu de test localement ou distant,

- Le système bascule en mode veille et présente les informations issues des capteurs **1,4** au compteur d'énergie **2**.

La fonction compteur d'énergie n'est pas forcement indépendante de la fonction vérification. Dans un mode de réalisation particulier, elle est intégrée dans une fonction plus complète qui est la télérelève.

Le système selon l'invention est capable de simuler l'ensemble des signaux représentatifs des tensions caténaires présents sur le territoire européen, ce qui présente un avantage considérable.

## Revendications

1. Procédé pour vérifier si un compteur d'énergie électrique embarqué dans un véhicule ferroviaire est en bon état de calibration, l'engin ferroviaire comportant une alimentation de traction (3) en liaison électrique avec un capteur de mesure de tension (1) et un capteur de mesure de courant (4), ainsi qu'un vérificateur embarqué (10), ledit vérificateur embarqué (10) comprenant un simulateur des références (6), une unité de gestion (5), un premier commutateur (8) en liaison électrique avec le capteur de mesure de tension (1), et un deuxième commutateur (9) en liaison électrique avec le capteur de mesure de courant (4), lesdits capteurs (1,4) étant situés à l'extérieur dudit vérificateur embarqué (10) et en liaison électrique avec l'alimentation de traction (3), dans lequel :
- on reçoit un ordre local ou distant de test ;
- on initialise la vérification dudit compteur d'énergie électrique (2), en effectuant les étapes suivantes :
(A) on initialise le dialogue entre le compteur d'énergie électrique (2) et le vérificateur embarqué (10) ;
(B) le vérificateur embarqué (10) passe du mode dit « comptage » en mode dit « vérification », en basculant les premier et deuxième commutateurs (8, 9) d'une première position (a) vers une deuxième position (b), de manière à ce que les signaux électriques issus des capteurs (1, 4) et précédemment envoyés vers le compteur d'énergie électrique (2) sont remplacées par les signaux étalon E générés par le simulateur des références (6),
(C) on effectue les étapes suivantes :
(i) on injecte par l'intermédiaire du vérificateur embarqué (10) au moins un signal étalon E de caractéristiques connues soit dans ledit instrument de mesure soit dans un circuit situé en amont dudit compteur d'énergie électrique (2), ledit signal étalon E se situant à l'intérieur d'une plage dite « plage d'étalonnage »,
(ii) on mesure pour chacun desdits signaux étalon E la réponse R(E) en sortie dudit instrument de mesure ;
(iii) on compare chaque réponse R(E) mesurée à un intervalle de confiance jugé acceptable associé au signal étalon E qui a été injecté,
(iv) si pour chaque signal étalon E, cette réponse R(E) se situe à l'intérieur de l'intervalle de confiance jugé acceptable, on décide que ledit instrument de mesure est toujours en bon état de calibration,
(v) si pour un quelconque signal étalon E cette réponse R(E) se situe à l'extérieur de l'intervalle de confiance jugé acceptable, on décide que ledit instrument de mesure n'est plus en bon état de calibration ;
(D) on établit un compte rendu de test, soit localement soit à distance ;
(E) le vérificateur embarqué (10) passe du mode de vérification en mode comptage, en basculant les premier et deuxième commutateurs (8, 9) de la deuxième position (b) en première position (a), de manière à ce que les signaux étalon E issus du simulateur des références (6) qui étaient à l'étape (B) envoyés vers le compteur d'énergie électrique (2) sont remplacées par les signaux issus des capteurs (1, 4),
sachant que l'étape (D) peut être effectuée avant ou après l'étape (E), ou encore pendant l'étape (C-vi) et/ou (C-v).

2. Procédé selon la revendication 1, dans lequel on utilise une pluralité de n signaux étalon E₁, ..., Eₙ qui sont réparties selon un schéma prédéfini sur la plage d'étalonnage.

3. Procédé selon la revendication 1, dans lequel ledit signal étalon E est sélectionné parmi les signaux électriques en courant continu et les signaux électriques en courant alternatif, et dans ce dernier cas avantageusement dans le groupe formé par les signaux électriques en courant alternatif de fréquence nominale 50 Hz et les signaux électriques en courant alternatif de fréquence nominale 16 Hz 2/3.

4. Procédé selon l'une quelconque des revendications 1 à 3, **caractérisé en ce qu'**il comprend en plus une étape de transmission d'informations sur l'état de calibration dudit instrument de mesure embarqué par un émetteur embarqué de signal sans fil et relié au vérificateur embarqué (10) vers un récepteur externe audit engin ferroviaire, ladite transmission d'information étant effectuée par l'intermédiaire d'une liaison sans fil.

5. Engin ferroviaire comportant une alimentation de traction électrique, en particulier un engin de traction ferroviaire tel que locomotive, autorail, motrice ferroviaire, automotrice, rame à motorisation répartie, l'engin ferroviaire comportant des moyens configurés pour mettre en oeuvre le procédé selon l'une quelconque des revendications 1 à 4,
l'alimentation de traction (3) étant en liaison électrique avec un capteur de mesure de tension (1) et un capteur de mesure de courant (4),
l'engin ferroviaire comportant en outre :
- un vérificateur embarqué (10) qui comporte un simulateur de références (6), et qui est conçu pour vérifier si un compteur d'énergie électrique (2) embarqué dans ledit engin ferroviaire est en bon état de calibration,
- une unité de gestion (5),
- un premier commutateur (8) en liaison électrique avec le capteur de mesure de tension (1),
- un deuxième commutateur (9) en liaison électrique avec le capteur de mesure de courant (4), lesdits capteurs (1,4) étant situés à l'extérieur dudit vérificateur embarqué (10) et en liaison électrique avec l'alimentation de traction (3).

6. Engin ferroviaire selon la revendication 5,
**caractérisé en ce qu'**il comprend un émetteur de signal sans fil qui est relié au vérificateur embarqué (10) par une liaison filaire ou sans fil,
et **en ce que** ledit émetteur de signal sans fil est capable de transférer des informations sur l'état de calibration dudit instrument de mesure (2) vers un récepteur externe audit engin ferroviaire, par l'intermédiaire d'une liaison sans fil.,

## Patentansprüche

1. Verfahren zur Überprüfung, ob ein an Bord eines Schienenfahrzeugs installierter Elektrizitätszähler in gutem Kalibrierungszustand ist, wobei das Schienenfahrzeug eine mit einem Spannungsmesssensor (1) und einem Strommesssensor (4) elektrisch verbundene Antriebsversorgung (3) sowie einen an Bord installierten Überprüfer (10) aufweist, wobei der an Bord installierte Überprüfer (10) einen Referenzsimulator (6), eine Verwaltungseinheit (5), einen mit dem Spannungsmesssensor (1) elektrisch verbundenen ersten Schalter (8) und einen mit dem Strommesssensor (4) elektrisch verbundenen zweiten Schalter (9) umfasst, wobei die Sensoren (1, 4) außerhalb des an Bord installierten Überprüfers (10) liegen und mit der Antriebsversorgung (3) elektrisch verbunden sind, wobei:
- eine lokale oder entfernte Testanweisung erhalten wird;
- die Überprüfung des Elektrizitätszählers (2) unter Durchführung der folgenden Schritte initialisiert wird:
(A) der Dialog zwischen dem Elektrizitätszähler (2) und dem an Bord installierten Überprüfer (10) wird initialisiert;
(B) der an Bord installierte Überprüfer (10) geht vom sogenannten "Zähl"-Modus in den sogenannten "Überprüfungs"-Modus durch Umschalten des ersten und zweiten Schalters (8, 9) von einer ersten Position (a) auf eine zweite Position (b) über, sodass die von den Sensoren (1, 4) ausgegebenen und zuvor an den Elektrizitätszähler (2) gesendeten elektrischen Signale durch die Standardsignale E, die durch den Referenzsimulator (6) erzeugt werden, ersetzt werden,
(C) die folgenden Schritte werden durchgeführt:
(i) mithilfe des an Bord installierten Überprüfers (10) wird mindestens ein Standardsignal E mit bekannten Merkmalen entweder in das Messinstrument oder in einen dem Elektrizitätszähler (2) vorgelagert gelegenen Stromkreis eingegeben, wobei das Standardsignal E innerhalb eines Bereichs, "Standardisierungsbereich" genannt, liegt,
(ii) für jedes der Standardsignale E wird die Antwort R(E) am Ausgang des Messinstruments gemessen;
(iii) jede gemessene Antwort R(E) wird mit einem als akzeptabel erachteten Konfidenzintervall, das mit dem eingegebenen Standardsignal E verknüpft ist, verglichen,
(iv) wenn diese Antwort R(E) für jedes Standardsignal E innerhalb des als akzeptabel erachteten Konfidenzintervalls liegt, wird entschieden, dass das Messinstrument noch in gutem Kalibrierungszustand ist,
(v) wenn diese Antwort R(E) für ein beliebiges Standardsignal E außerhalb des als akzeptabel erachteten Konfidenzintervalls liegt, wird entschieden, dass das Messinstrument nicht mehr in gutem Kalibrierungszustand ist;
(D) ein Testbericht wird erstellt, entweder lokal oder aus der Entfernung;
(E) der an Bord installierte Überprüfer (10) geht vom Überprüfungsmodus in den Zählmodus durch Umschalten des ersten und zweiten Schalters (8, 9) von der zweiten Position (b) in die erste Position (a) über, sodass die vom Referenzsimulator (6) ausgegebenen Standardsignale E, die während des Schritts (B) an den Elektrizitätszähler (2) gesendet wurden, durch die Signale ersetzt werden, die durch die Sensoren (1, 4) ausgegeben werden,
hierbei ist festzuhalten, dass der Schritt (D) vor oder nach dem Schritt (E) oder auch während des Schritts (C-vi) und/oder (C-v) durchgeführt werden kann.

2. Verfahren nach Anspruch 1, wobei eine Vielzahl von n Standardsignalen E₁, ..., Eₙ verwendet werden, die gemäß einem vordefinierten Schema über den Standardisierungsbereich verteilt sind.

3. Verfahren nach Anspruch 1, wobei das Standardsignal E ausgewählt ist aus den elektrischen Gleichstromsignalen und den elektrischen Wechselstromsignalen, und in diesem letzten Fall vorteilhafterweise aus der Gruppe, die gebildet ist aus den elektrischen Wechselstromsignalen einer nominalen Frequenz von 50 Hz und den elektrischen Wechselstromsignalen einer nominalen Frequenz von 16 Hz 2/3.

4. Verfahren nach einem der Ansprüche 1 bis 3, **dadurch gekennzeichnet, dass** es weiter einen Informationsübertragungsschritt über den Kalibrierungszustand des an Bord installierten Messinstruments durch einen an Bord installierten drahtlosen und mit dem an Bord installierten Überprüfer (10) verbundenen Signalgeber an einen externen Empfänger des Schienenfahrzeugs umfasst, wobei die Informationsübertragung mithilfe einer drahtlosen Verbindung durchgeführt wird.

5. Schienenfahrzeug, das eine elektrische Antriebsversorgung aufweist, insbesondere ein Schienentriebfahrzeug wie beispielsweise eine Lokomotive, ein Triebwagen, ein schienengebundenes elektrisches Triebfahrzeug, ein selbstfahrendes Fahrzeug, ein Zugteil mit verteilter Motorisierung, wobei das Schienenfahrzeug Mittel umfasst, die konfiguriert sind, um das Verfahren nach einem der Ansprüche 1 bis 4 umzusetzen,
wobei die Antriebsversorgung (3) mit einem Spannungsmesssensor (1) und einem Strommesssensor (4) elektrisch verbunden ist,
wobei das Schienenfahrzeug weiter umfasst:
- einen an Bord installierten Überprüfer (10), der einen Referenzsimulator (6) aufweist und der vorgesehen ist, um zu überprüfen, ob ein an Bord des Schienenfahrzeugs installierter Elektrizitätszähler (2) in gutem Kalibrierungszustand ist,
- eine Verwaltungseinheit (5),
- einen ersten Schalter (8), der mit dem Spannungsmesssensor (1) elektrisch verbunden ist,
- einen zweiten Schalter (9), der mit dem Strommesssensor (4) elektrisch verbunden ist, wobei die Sensoren (1, 4) außerhalb des an Bord installierten Überprüfers (10) liegen und mit der Antriebsversorgung (3) elektrisch verbunden sind.

6. Schienenfahrzeug nach Anspruch 5,
**dadurch gekennzeichnet, dass** es einen drahtlosen Signalgeber umfasst, der mit dem an Bord installierten Überprüfer (10) durch eine Drahtverbindung oder drahtlose Verbindung verbunden ist,
und dadurch, dass der drahtlose Signalgeber imstande ist, Informationen über den Kalibrierungszustand des Messinstruments (2) an einen externen Empfänger des Schienenfahrzeugs mithilfe einer drahtlosen Verbindung zu übertragen.

## Claims

1. Method for verifying if an electrical energy meter on board a railway vehicle is in a good state of calibration, the railway vehicle comprising a traction power supply (3) with an electrical connection to a voltage measurement sensor (1) and a current measurement sensor (4), as well as an onboard verifier (10), said onboard verifier (10) comprising a reference simulator (6), a management unit (5), a first switch (8) with an electrical connection to the voltage measurement sensor (1), and a second switch (9) with an electrical connection to the current measurement sensor (4), said sensors (1, 4) being located outside said onboard verifier (10) and with an electrical connection to the traction power supply (3), wherein:
- a local or remote test order is received;
- the verification of said electrical energy meter (2) is initialised, by carrying out the following steps:
(A) the dialogue is initialised between the electrical energy meter (2) and the onboard verifier (10);
(B) the onboard verifier (10) switches from a termed "metering" mode to a termed "verification" mode, by switching the first and second switches (8, 9) from a first position (a) to a second position (b), such that the electrical signals coming from the sensors (1, 4) and previously sent to the electrical energy meter (2) are replaced with the standard signals E generated by the reference simulator (6),
(C) the following steps are carried out:
(i) by the intermediary of the onboard verifier (10) at least one standard signal E of known characteristics is applied either to said measurement instrument or to a circuit located upstream of said electrical energy meter (2), said standard signal E being within a range called "calibration range",
(ii) the response R(E) at the output of said measurement instrument is measured for each one of said standard signals E;
(iii) each response R(E) measured is compared with a confidence interval deemed as acceptable combined with the standard signal E that was applied,
(iv) if for each standard signal E, this response R(E) is within the confidence interval deemed as acceptable, it is decided that said measurement instrument is still in a good calibration state,
(v) if for any standard signal E, this response R(E) is outside of the confidence interval deemed as acceptable, it is decided that said measurement instrument is no longer in a good state of calibration;
(D) a test report is established, either locally or remotely;
(E) the onboard verifier (10) switches from verification mode to metering mode, by switching the first and second switches (8, 9) from the second position (b) to the first position (a), such that the standard signals E coming from the reference simulator (6) that were in the step (B) sent to the electrical energy meter (2) are replaced with the signals coming from the sensors (1, 4),
keeping in mind that step (D) can be carried out before or after step (E), or during step (C-vi) and/or (C-v).

2. Method according to claim 1, wherein a plurality of n standard signals E₁..., Eₙ is used which are distributed according to a predefined schema over the calibration range.

3. Method according to claim 1, wherein said standard signal E is selected from direct current electrical signals and alternating current electrical signals, and in the latter case advantageously in the group formed by alternating current electrical signals with a nominal frequency of 50 Hz and alternating current electrical signals with a nominal frequency of 16 Hz 2/3.

4. Method according to any one of claims 1 to 3, **characterised in that** it comprises in addition to the step of transmitting information on the state of calibration of said onboard measurement instrument by an onboard wireless signal transmitter and connected to the onboard verifier (10) to a receiver that is external to said railway vehicle, said transmission of information being carried out by means of a wireless connection.

5. Railway vehicle comprising a traction electrical power supply, in particular a railway traction vehicle such as a locomotive, railcar, railway engine, self-propelled vehicle, distributed power trainset, the railway vehicle comprising means configured to implement the method according to any one of claims 1 to 4,
the traction power supply (3) being with an electrical connection to a voltage measurement sensor (1) and a current measurement sensor (4),
the railway vehicle further comprising:
- an onboard verifier (10) which comprises a reference simulator (6), and which is designed to check if an electrical energy meter (2) on board said railway vehicle is in a good state of calibration,
- a management unit (5),
- a first switch (8) with an electrical connection to the voltage measurement sensor (1),
- a second switch (9) with an electrical connection to the current measurement sensor (4), said sensors (1, 4) being located outside said onboard verifier (10) and with an electrical connection to the traction power supply (3).

6. Railway vehicle according to claim 5,
**characterised in that** it comprises a wireless signal transmitter that is connected to the onboard verifier (10) by a wired or wireless connection,
and **in that** said wireless signal transmitter is able to transfer information on the state of the calibration of said measurement instrument (2) to a receiver that is external to said railway vehicle, by means of a wireless connection.
